Europäisches Patentamt

(19) European Patent Office

Office européen des brevets

(11) Publication number: 0 278 748
A2

# (12) EUROPEAN PATENT APPLICATION

(21) Application number: 88301119.9

(22) Date of filing: 10.02.88

(51) Int. Cl.⁴: H 05 K 1/16
H 05 K 1/00

(30) Priority: 11.02.87 GB 8703168

(43) Date of publication of application:
17.08.88 Bulletin 88/33

(84) Designated Contracting States:
DE ES FR GB IT NL SE

(71) Applicant: AUSTIN ROVER GROUP LIMITED
Fletchamstead Highway
Canley Coventry CV4 9DB (GB)

(72) Inventor: Monks, Arthur
49 Dreyer Close
Rugby CV22 7SX (GB)

(74) Representative: Muir, Peter Richard et al
The Rover Group plc Patent Department Cowley Body
Plant
Cowley Oxford OX4 5NL (GB)

(54) A printed circuit board and apparatus for recording data thereon.

(57) A printed circuit board (11) is described having a number of functional electrically conductive tracks (12) used to connect together the operative components and a number of further tracks (13) not connected to the functional tracks (12).

The further tracks (13) include a number of fusible links (16) which can be failed by the application of excessive current to produce a binary data record of certain events.

Fig. 1

EP 0 278 748 A2

Bundesdruckerei Berlin

## Description

## A PRINTED CIRCUIT BOARD AND APPARATUS FOR RECORDING DATA THEREON

This invention relates to printed circuit boards and in particular to a printed circuit board having means to record data relating to the printed circuit board formed as part of the printed circuit board.

It is well known to provide an electrical circuit by printing on to a non-conductive plate or board a conductive material in the form of tracks which link the operating components on the board together, such an arrangment is called a printed circuit board or "pcb".

It is a problem with known circuit boards that details regarding the manufacturer or exact specification of the pcb are difficult to cheaply and quickly record in the limited space available.

During the life of the pcb it is also a problem that pcb's are returned to the supplier as faulty but upon testing are found to be operating correctly such unnecessary testing by the supplier is both costly and time consuming. It would be desirable for a cheap method of recording whether the pcb has been fully checked before it was returned and also the details of the servicing agency so that in the case of a "no fault found" situation the unnecessary cost can be levied against the servicing agent concerned.

According to a first aspect of the invention there is provided a printed circuit board having functional electrically conductive tracks required to operatively connect the components associated with the printed circuit board and at least one further electrically conductive track not connected to the functional electrically conductive tracks, the or each further electrically conductive track having a portion forming a fusible link such that when a current at or above a pre-determined level is applied to the or each further electrically conductive track the fusible link associated therewith will fail thereby providing a permanent record of the application of the current.

This has the advantage that the fusible link or links used to provide the permanent record cost virtually nothing to provide as originally the whole of the surface is conductive but selective parts are etched away during manufacture to leave the functional tracks and in this case the fusible links.

According to a second aspect of the present invention there is provided apparatus for recording binary data on a printed circuit board according to the first aspect of the invention, the apparatus including a source of electrical current capable of producing sufficient current to produce failure of a fusible link if connected thereto, connection means to connect, when in use, the source to the or each link and switching means to selectively connect the source to the or each fusible link by means of the connection means.

This has the advantage that a permanent record is made.

According to a third aspect of the invention there is provided apparatus for reading binary data encoded on a printed circuit board according to the first aspect of the invention, the apparatus including a further source of electrical current of magnitude less than that required to produce failure of the or each fusible link, connection means to connect, when in use, the further source to the or each link, sensing means to detect whether current is flowing through the or each link and thereby the condition of the respective link and output means, connected to the sensing means to provide an operator interpretable output of the condition of the or each link.

According to a fourth aspect of the invention there is provided a method of recording data on a printed circuit board according to the first aspect of the present invention the method comprising the steps of connecting the or each fusible link required to indicate the event which is to be recorded to a source of electrical current and causing sufficient current to flow from said source to produce failure of the fusible links connected thereto.

The invention will now be described by way of example with reference to the following drawings of which:

Fig 1 is a plan view of a printed circuit board according to a first aspect of the invention;

Fig 2 is a schematic view of an integrated test and data logging system including apparatus according to the second and third aspects of the invention.

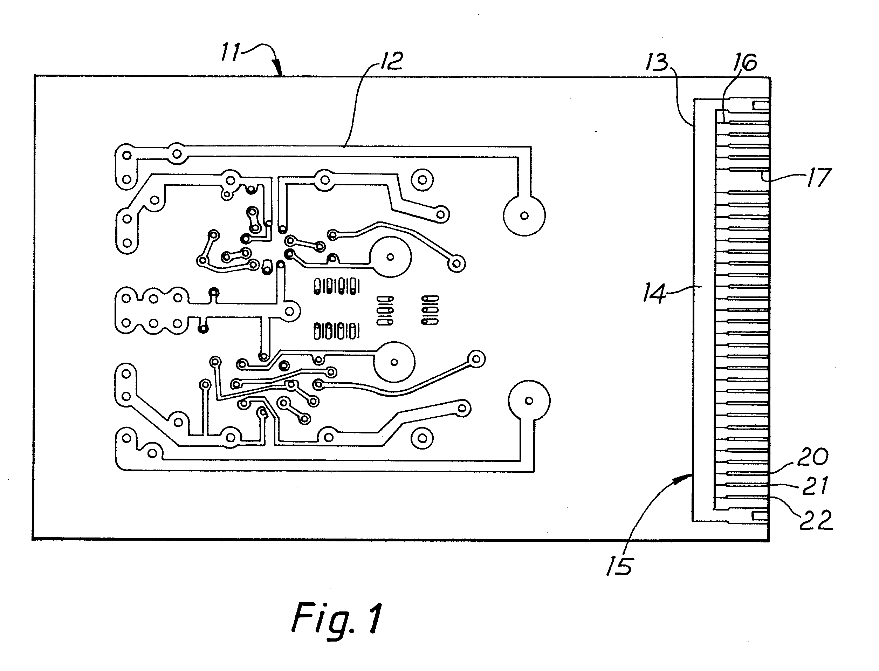

With reference to Fig 1 there is shown a printed circuit board 11 having a number of functional electrically conductive tracks 12 and a further electrically conductive track 13.

The functional tracks 12 are provided to operationally connect the electronic components (not shown) associated with the printed circuit board 11.

The further electrically conductive track 13 is spaced apart slightly from the functional tracks 12 and is not connected to the functional tracks 12.

The track 13 comprises a plurality of fusible links 16 each joined at one end to a common track 14 and at the other end to a conductive pad 17.

The functional tracks 12 and the track 13 are both formed by photoetching an originally continuous conductive surface to leave just the required conductive material, such processes are well known in the art.

The common track 14, the fusible links 16 and the conductive pads 17, 20, 21, 22 form a binary data recorder 15.

The binary data recorder 15 is positioned near to one edge of the printed circuit board 11 so that the connection to the conductive pads 17 can be readily made by means of an edge connector (not shown). It would of course be possible to position the recorder 15 elsewhere on the printed circuit board 11 but connection might then be more difficult.

Operation of the binary data recorder 15 is as follows if one of the fusible links 16 is connected by means of its respective conductive pad 17 and the common track 14 to a source of electrical current such as a battery (not shown) then provided the current is sufficient the respective fusible link 16 will fail but the respective conductive pad 17 and the common track 14 will remain intact. The failure of the fusible link 16 thereby provides a record of the fact that such a current has been applied to it to cause it to fail and if each of the fusible links 16 is assigned a value depending upon whether it is intact or not this value is effectively stored for further use.

If at a later date the value stored needs to be checked it is only necessary to determine which of the links 16 are intact and which have failed and use the value assigned to the respective to translate that data into a date, or details of manufacture.

For example, one of the links could be used to record whether the pcb has been tested for faults, further links could be used to record faults found during testing details of manufacturer, batch number, specification of the printed circuit board, the identity of the test equipment used to test the circuit board 11 or any other relevant details.

For example, if the conductive pads 20, 21, 22 and their respective fusible links 16 are allocated to recording the details of who manufactured the printed circuit board then up to 8 different manufacturers can be identified by allocation of the value 0 for intact or 1 for a failed fusible link 16 associated with pad 22, 0 for intact or 2 for a failed fusible link 16 associated with pad 21 and 0 for intact or 4 for a failed fusible link 16 associated with pad 20.

By printed circuit board it is meant the actual board having the circuits on it and the components associated with these circuits.

The provision of 32 fusible links 16 such as shown allows for in excess of 4,000 million different total values to be recorded each of which could be assigned a different meaning.

Although the fusible links 16 as shown in Fig 1 are of a uniform width it would be possible for each of the fusible links to have a first portion which will fail upon the application of a pre-determined current for a pre-determined period of time and a second portion which will not fail until a slightly higher current is supplied for the pre-determined time or the pre-determined current is passed for a period of time slightly longer than the pre-determined period. The provision of two portions would further restrict unscrupulous manufacturers from easily recording incorrect data in the binary data recorder.

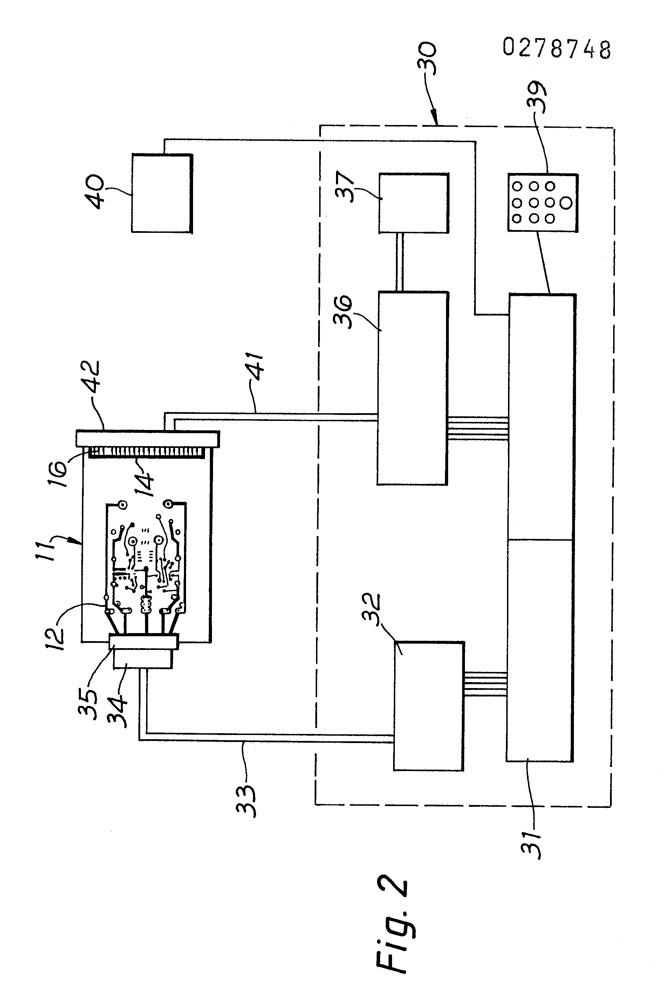

With respect to Fig 2 there is shown an integrated test and data logging system 30 for testing and recording data relating to the printed circuit board 11 of the type previously referred to with respect to Fig 1.

The system 30 includes a programmable means in the form of a microcomputer 31, a test interface 32, a switching means 36, a source of electric current 37 and means to input control signals to the microcomputer 31 in the form of a keypad 39.

The system 30 performs two separate functions, firstly that of a test system formed by the microcomputer 31 and the interface 32 and secondly that of a data logging system formed by the microcomputer 31, the switching means 36 and the source 37.

In operation the test system functions in the following manner, in response to a control input from the keypad 39 the microcomputer 31 sends a control signal to the interface 32 which then sends a test signal by means of the multicore cable 33 and the plug and socket 34 and 35 to the functional tracks 12 of the printed circuit board 11 and monitors the response of the circuit under test. The interface 32 then sends a signal back to the microcomputer 31 indicating the result of the test which the microcomputer 31 analyses and displays on the video monitor 40 in an operator interpretable form and in addition sends a signal to the switching means 36 to connect the fusible links 16 which it is required to fail, to record the result of the test, to the source of electric current 37 by means of a multicore cable 41 and an edge connecting socket 42.

After completing the recording of the data, the data stored on the printed circuit board is checked against the data which should have been recorded in the reading mode. The microcomputer 31 now connects each of the fusible links 16 to a further source of current below that needed to fail the fusible link and checks whether a circuit is made or not made. The result of this checking is then compared with the desired result by the microcomputer 31 and a corresponding output is displayed on the monitor 40.

Additional information regarding the date of testing or other manufacturing details can be recorded by using the keypad 39 in a direct entry mode in which data entered via the keypad 39 is translated by the microcomputer 31 into a corresponding control signal to the switching means 36.

Alternatively, the system 30 can be used to simply read any of the data stored as previously described and translate this into an operator interpretable display on the monitor 40 by inputting the appropriate command via the keypad 39.

It will be appreciated by those skilled in the art that the test, recording and reading functions could be performed by separated pieces of equipment and that access to the links could be selective so that for example, only a manufacturer could record data relating to the manufacture of the printed circuit board.

It will also be appreciated that the method of inputing command signals is not limited to a keypad, other means such as magnetic cards or optically coded cards could be used.

Similarly, the output means is not limited to a video monitor results could be outputed by means of a printer or could be transferred to a computer for further analysis or to an automatic repair machine.

Although as described only one binary data recorder is shown there could, of course, be more than one each used for a different purpose.

## Claims

1. A printed circuit board (11) having functional electrically conductive tracks (12) required to operatively connect the components associated with the printed circuit board, characterised in that the printed circuit board, has at least one further electrically conductive track (13) not connected to the functional electrically conductive tracks (12), the or each further electrically conductive track (13) having a portion forming a fusible link (16) such that when a current at or above a pre-determined level is applied to the or each further electrically conductive track (13) the fusible link (16) associated therewith will fail thereby providing a permanent record of the application of the current.

2. A printed circuit board (11) as claimed in claim 1 in which there are a plurality of fusible links (16) forming a binary data recorder (15).

3. A printed circuit board (11) as claimed in claim 2 in which each of the fusible links (16) is joined at one end to a common track (14) linking all the fusible links (16) of the respective binary data recorder (15) together and at the other end to an individual conductive pad (17), (20), (21), (22).

4. A printed circuit board (11) as claimed in claim 3 in which the fusible links (16) are positioned near to one of the edges of the printed circuit board 11 so that connection to the conductive pads (17, (20), (21), (22) and the common track (14) is made by an edge connector.

5. A printed circuit board (11) as claimed in any of claims 2 - 4 in which at least one of the fusible links (16) is utilised to record whether the printed circuit board (11) has been tested for faults.

6. A printed circuit board (11) as claimed in any of claims 2 - 5 in which at least two of the fusible links (16) are utilised to record the source of manufacture of the printed circuit board (11).

7. A printed circuit board (11) as claimed in any of claims 2 - 6 in which at least two of the fusible links (16) are utilised to record the specification to which the printed circuit board (11) is constructed.

8. A printed circuit board (11) as claimed in any of claims 2 - 7 in which at least two of the fusible links (16) are utilised to record a fault found during testing.

9. A printed circuit board (11) as claimed in any of claims 2 - 8 in which at least two of the fusible links (16) are utilised to record the identity of test equipment (30) used to test the printed circuit board (11). .

10. A printed circuit board (11) as claimed in any of claims 2 - 9 on which there are at least two binary data recorders (15).

11. A printed circuit board (11) as claimed in any preceding claim in which the or each fusible link (16) has a first portion which will fail upon the application of a pre-determined current for a predetermined length of time and at least one further portion which will not fail until a higher current than the predetermined current is applied for the pre-determined length of time.

12. A printed circuit board (11) as claimed in any of claims 1 - 10 in which the or each fusible link (16) has a first portion which will fail upon the application of a pre-determined current for a pre-determined length of time and at least one further portion which will not fail until the pre-determined current is applied for a period longer than the pre-determined length of time.

13. Apparatus for recording binary data on a printed circuit board (11) according to any one of the preceding claims characterised in that the apparatus includes a source of electrical current (37) capable of producing sufficient current to produce failure of a fusible link (16) if connected thereto, connection means to connect, when in use, the source (37) to the or each link (16) and switching means 36 to selectively connect the source (37) to the or each fusible link (16) by means of the connection means.

14. Apparatus as claimed in claim (13) wherein the apparatus further includes programmable means (31) to control the switching means (36) in response to an input signal supplied from control means (39).

15. Apparatus as claimed in claim 14 wherein the control means is an operator controlled keypad (39).

16. Apparatus as claimed in claim 14 wherein the input signal is generated by a fault test system (31), (32) utilised to test the printed circuit board (11) for faults.

17. Apparatus as claimed in claim 14 wherein the input signal is generated by a magnetic card reader.

18. Apparatus as claimed in claim 14 wherein the unput signal is generated by an optical card reader.

19. Apparatus as claimed in claim 14 in which the programmable means (31) is connectible to the functional electrically conductive tracks (12) and is so programmed as to cause the supply of a test signal thereto, to analyse the test result and to supply a control signal to the switching means (36) to couple the source (37) to one or more of the fusible links (16).

20. Apparatus for reading binary data encoded on a printed circuit board (11) as claimed in any one of claims 1 - 12, the apparatus being characterised by including a further source of electrical current of magnitude less than that required to produce failure of the or each fusible link (16), connection means to connect, when in use, the furthest source to the or each link (16) sensing means (31) to detect whether current is flowing through the or each link (16) and thereby the condition of the respective link (16) and output means (40), connected to the sensing means (31) to provide an operator interpretable output of the condition of the or each link (16).

21. A method of recording data on a printed circuit board (11) according to claim 1, characterised by the steps of connecting the or each fusible link (16) required to indicate the event which is to be recorded to a source of electrical current (37) and causing sufficient current to flow from said source (37) to produce failure of the or each fusible link (16) connected thereto.

Fig.1

Fig. 2